# EUROPÄISCHE PATENTSCHRIFT

(11) **EP 2 467 870 B1**
(45) Veröffentlichungstag und Bekanntmachung des Hinweises auf die Patenterteilung: **23.10.2019**
(21) Anmeldenummer: 10742861.7
(22) Anmeldetag: 18.08.2010
(51) Int. Cl.: H01L 21/68, H01L 21/67

(54) **VERFAHREN UND VORRICHTUNG ZUM ERMITTELN EINER DEFORMATION EINES SCHEIBENFÖRMIGEN WERKSTÜCKS, INSBESONDERE EINES MOLDWAFERS**
METHOD AND DEVICE FOR DETERMINING A DEFORMATION OF A DISK-SHAPED WORKPIECE, PARTICULARLY A MOLD WAFER
PROCÉDÉ ET DISPOSITIF DE DÉTERMINATION D'UNE DÉFORMATION D'UNE PIÈCE EN FORME DE DISQUE, EN PARTICULIER D'UNE PLAQUETTE MOULÉE

(30) Priorität: 19.08.2009 DE 102009037939
(43) Veröffentlichungstag der Anmeldung: 27.06.2012
(73) Patentinhaber: ERS electronic GmbH, 82110 Germering (DE)
(72) Erfinder: SCHINDLER, Rüdiger, 96465 Neustadt - Birkig (DE)
(74) Vertreter: Isarpatent
(86) Internationale Anmeldenummer: PCT/EP2010/062056
(87) Internationale Veröffentlichungsnummer: WO 2011/020860

(56) Entgegenhaltungen:
- EP-A1- 1 821 065
- WO-A1-99/52686
- KR-A- 20080 065 392
- US-A- 4 457 664
- US-A- 4 750 141
- US-A- 4 931 962
- US-A1- 2002 071 129
- US-A1- 2005 255 610

## Beschreibung

Die vorliegende Erfindung betrifft ein Verfahren und eine Vorrichtung zum Ermitteln einer Deformation eines Mouldwafers.

Aus der US 2002/071129 A1 ist ein Verfahren zum Ermitteln einer Deformation eines Wafers bekannt, welches folgende Schritte aufweist: Ablegen des Wafers auf eine Ablageeinrichtung, Aufspannen des Innenbereichs des Wafers auf eine Aufspanneinrichtung, wobei die Exzentrizität in der Aufspannposition im Wesentlichen Null ist, und Messen einer jeweiligen Abweichung von mehreren Messpunkten in einem nicht aufgespannten Außenbereich des Werkstücks von einer vorgegebenen Höhenposition entsprechend der Deformation mittels einer Detektoreinrichtung durch Drehen der Aufspanneinrichtung auf entsprechende Drehwinkel.

Die KR 2008/0065392A offenbart eine Vakuumaufspannvorrichtung für Wafer, wobei ein oder mehrere Auflagestifte durch eine Ablageeinrichtung geführt sind, welche zum Ablegen des Wafers auf die Ablageeinrichtung zurückziehbar sind. An der Oberseite der Ablageeinrichtung sind die Ablagestifte durch eine Dichtlippe geführt. Im aufgespannten Zustand sind die Ablagestifte so weit ins Innere der Ablageeinrichtung zurückgezogen, dass durch die Dichtlippe Vakuum an den Wafer angelegt werden kann und dadurch der wafer auf der Ablageeinrichtung eingespannt werden kann.

Im Bereich der Halbleitertechnologie werden scheibenförmige Werkstücke, die in diesem Fall als Wafer bezeichnet werden, in der Regel in einer Linienverarbeitungskette, d.h. in Rahmen einer Fließfertigung in mehreren aufeinander folgenden Vorrichtungen, die abgestimmte Verfahrensschritte durchführen, verarbeitet.

Bei der Waferverarbeitung wird hierbei eine exakte Ausrichtung des Wafers vor der Weiterverarbeitung, insbesondere vor dem Aussägen der einzelnen Chips aus dem Wafer oder einer elektrischen Kontaktierung der Chips notwendig. Hierzu werden sogenannte Werkstückausrichtvorrichtungen, die im Bereich der Halbleiterindustrie auch als Waferalignmentsysteme bekannt sind, verwendet.

Aus dem Stand der Technik ist hierzu beispielsweise aus der US 6,275,742 B1 ein Alignmentsystem bekannt, das eine exakte Ausrichtung eines scheibenförmigen Werkstücks, insbesondere eines Wafers mittels eines optischen Verfahrens vornehmen kann.

Aus der JP 01-267403 A ist eine Vorrichtung zur Bestimmung der Durchbiegung eines scheibenförmigen Werkstücks bekannt, durch die mittels einer optischen Detektorvorrichtung die Deformation an Umfangspunkten des Werkstückes ermittelbar ist.

Weitere Vorrichtungen und Verfahren einer Deformation eines scheibenförmigen Werkstücks, insbesondere von Wafern, offenbaren die JP 10-078310 A, die JP 06-163661 A, die US 2006/0280085 A1, die US 4,750,141 A und die US 7,301,623 B1.

Allen diesen bekannten Vorrichtungen ist gemeinsam, dass die Deformation nicht exakt bestimmbar ist, da die Messverfahren bzw. Einspannvorrichtungen das Messergebnis verfälschen.

In jüngerer Zeit ist in der Halbleiterindustrie ein Trend zu so genannten Compound-Wafern oder Moldwafern zu verzeichnen, d.h. zu zusammengesetzten künstlich erstellten Wafern, die durch das Zusammensetzen einzelner Chips zu einem waferförmigen Gebilde erzeugt werden, wobei die Chips mittels einer Kunststoffvergussmasse wieder in eine scheibenförmige Struktur verklebt werden. Solche Moldwafer, aber auch herkömmliche dünne Wafer aus Silizium o.ä., besitzen neben einer kreisrunden Struktur bedingt durch die vorangegangene thermische und mechanische Bearbeitung eine gewisse Durchbiegung in axialer Richtung, so dass diese scheibenförmigen Werkstücke nicht planar, sondern durchgebogen bzw. deformiert sind.

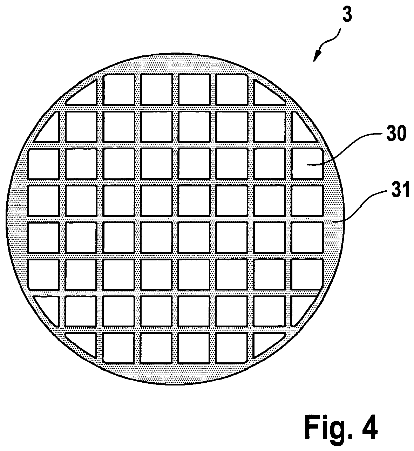

Fig. 4 ist eine schematische Draufsicht auf einen Moldwafer, der das Bezugszeichen 3 trägt, wobei die Kunststoff-Moldmasse mit 31 und die darin eingebetteten Halbleiterchips mit 30 bezeichnet sind. Nach Abziehen einer Schutzfolie liegen die Halbleiterchips 30 an einer Oberseite des Moldwafers 3 frei.

Da aufgrund der geringen Abmessungen der einzelnen Halbleiterchips 30 eine exakte Positionierung des Moldwafers 3 für nachfolgende Verarbeitungsschritte notwendig ist, muss eine exakte Ausrichtung gewährleistet werden, wobei eine Kenntnis des Durchbiegungsverhaltens des Moldwafers 3 notwendig ist.

Somit ergibt sich das Problem, die Durchbiegung bzw. Deformation eines solchen scheibenförmigen Werkstücks exakt zu bestimmen. Diese Problem wird umso dringlicher, als das die Moldwafer 3, die eine Zusammensetzung vieler einzelner Chips mittels einer Vergussmasse zu einer waferförmigen Struktur darstellen, eine hohe Eigenbiegung aufgrund unterschiedlicher thermischer Ausdehnungskoeffinzienten von Silizium und Kunststoff aufweisen, so dass kein Moldwafer 3 dem Anderen gleicht. Somit kann eine exakte Ausrichtung nur unter Berücksichtigung der individuellen Durchbiegung der Moldwafer 3 erfolgen, um eine Linienverarbeitung in hoher Stückzahl nach einem Fließbandprinzips zu ermöglichen.

Auch kann ein Grenzwert der Durchbiegung gesetzt werden, um nicht weiterverarbeitbare Moldwafer 3 auszusortieen.

Daher ist es Aufgabe der vorliegenden Erfindung, ein Verfahren und eine Vorrichtung zum Ermitteln einer Deformation eines Moldwafers anzugeben, welche die Deformation mit hoher Präzision bestimmen lassen, ohne dass es zu einer spürbaren Verfälschung des Messergebnisses durch die Messtechnik selbst kommt.

Das erfindungsgemäße Verfahren mit den Merkmalen des Anspruchs 1 bzw. die entsprechende Vorrichtung nach Anspruch 9 weisen gegenüber bekannten Lösungsansätzen den Vorteil auf, dass sie eine exakte Ermittlung der Deformation (warpage) ermöglichen.

Die der vorliegenden Erfindung zugrundeliegende Idee besteht darin, dass nach Eliminierung einer anfänglichen Exzentrizizät zwischen Mouldwafer und Aufspanneinrichtung eine Warpagemessung in einer definierten Höhenposition stattfinden kann.

Erfindungsgemäß lässt sich nach genauer Ausrichtung des Mouldwafers die Abweichung beliebig vieler Umfangsmesspunkte des Mouldwafers von der vorgegebenen Höhenposition ermitteln, indem die Aufspanneinrichtung um ihre eigene Achse gedreht wird oder indem die Detektoreinrichtung um die Achse der Aufspanneinrichtung gedreht wird.

Erfindungsgemäß können somit eine zweidimensionale Darstellung der Deformation entlang des Messumfangs eines bestimmten Messradius anhand der Abweichungen der jeweiligen Messpunkte erstellt werden. Aufgrund dieser Information kann bei Weiterverarbeitung des scheibenförmigen Mouldwafers die Durchbiegung berücksichtigt werden oder mittels einer mechanischen und/oder thermischen Nachbearbeitung die Durchbiegung korrigiert werden und/oder or bei Überschreiten eines vorgegebenen Grenzwerts aussortiert werden.

Erfindungsgemäß ist die Aufspanneinrichtung nicht nur drehbar, sondern auch höhen- und seitenverstellbar. Somit kann die vorgegebene Höhenposition zum Messen der Abweichungen der Messpunkte exakt eingestellt werden und beispielsweise thermische Veränderungen oder Vibrationen der erfindungsgemäßen Vorrichtung ausgeglichen werden.

In den Unteransprüchen finden sich vorteilhafte Weiterbildungen und Verbesserungen des betreffenden Gegenstandes der Erfindung.

Gemäss einer bevorzugten Weiterbildung wird die Ermittlung der Exzentrizität, um eine spätere Positionskorrektur zu ermöglichen, mit einem an sich bekannten Prealigner durchgeführt.

Gemäss einer bevorzugten Weiterbildung ist die Detektoreinrichtung radial verfahrbar, so dass die Deformation nicht nur an verschiedenen Winkelpositionen, sondern auch an verschiedenen Durchmessern vorgenommen werden kann. Hierdurch ist es möglich, eine dreidimensionale Dimension der Durchbiegung des scheibenförmigen Werkstücks zu erhalten.

Gemäss einer bevorzugten Weiterbildung umfasst die höhenfeste Detektoreinrichtung ein Lasermikrometer. Grundsätzlich können beliebige Arten von Detektoreinrichtungen zur Messung der Abweichungen, also zur Distanzmessung, verwendet werden, insbesondere mechanische, optoelektronische, schallbasierte Verfahren u.ä.. Besonders vorteilhaft kann eine berührungslos messende optische Mikrometereinheit eingesetzt werden, wobei sich insbesondere eine Lasermikrometereinheit auszeichnet, da sie eine sehr genaue Distanzmessung ermöglicht, ohne einen mechanischen Eingriff an dem Werkstück vorzunehmen.

Gemäss einer weiteren bevorzugten Weiterbildung wird die Aufspanneinrichtung in die zweite Aufspannposition durch eine Drehung vor dem Ablegen und eine seitliche Verstellung nach dem Ablegen verfahren.

Gemäss einer weiteren bevorzugten Weiterbildung weist der Innenbereich einen Durchmesser von 10% bis 30% des Außenbereichs auf.

Gemäss einer weiteren bevorzugten Weiterbildung wird eine Kalibrierung des Messens mit einem Normwerkzeug, z.B. einem Stahlwafer, ohne Deformation durchgeführt.

Gemäss einer weiteren bevorzugten Weiterbildung werden die jeweiligen Abweichungen von den mehreren Messpunkten zusammen mit den zugehörigen Drehwinkeln und einer Werkzeugkennung in einer Tabelle gespeichert.

Gemäss einer weiteren bevorzugten Weiterbildung werden die Drehwinkel relativ zu einer Werkzeugmarkierung gewählt. Eine derartige Werkzeugmarkierung kann beispielsweise eine Kerbe oder eine Abflachung oder eine optisch erkennbare Markierung sein.

Erfindungsgemäß erfolgt das Aufspannen einen Innenbereichs des scheibenförmigen Werkstücks mit einer Mehrzahl von Auflagestiften und einer Mehrzahl von Vakuum-Ansaugelementen.

Ausführungsbeispiele der Erfindung sind in den Zeichnungen dargestellt und in der nachfolgenden Beschreibung näher erläutert.

Es zeigen:
- Fig. 1a-c: schematische Querschnittsdarstellungen einer ersten Ausführungsform der erfindungsgemäßen Vorrichtung zum Ermitteln einer Deformation eines scheibenförmigen Werkstücks, insbesondere eines Moldwafers, entlag der Linie A-A' in Fig. 1f;
- Fig. 1d,e: schematische Seitenansichten der ersten Ausführungsform der erfindungsgemäßen Vorrichtung zum Ermitteln einer Deformation eines scheibenförmigen Werkstücks, insbesondere eines Moldwafers;
- Fig. 1f: eine schematische Draufsicht auf die erste Ausführungsform der erfindungsgemäßen Vorrichtung zum Ermitteln einer Deformation eines scheibenförmigen Werkstücks, insbesondere eines Moldwafers;
- Fig. 1g: eine Messdiagramm eines Moldwafers, dessen Defornation mitteks der erfindungsgemäßen Vorrichtung zum Ermitteln einer Deformation eines scheibenförmigen Werkstücks gemäß Fig. 1a-f ermittelt worden ist;
- Fig. 2: ein Fließdiagramm einer weiteren Ausführungsform des erfindungsgemäßen Verfahrens zum Ermitteln einer Deformation eines scheibenförmigen Werkstücks, insbesondere eines Moldwafers;
- Fig. 3: eine schematische perspektivische Ansicht einer zweiten Ausführungsform einer Vorrichtung zum Ermitteln einer Deformation eines scheibenförmigen Werkstücks, insbesondere eines Moldwafers; und
- Fig. 4: eine schematische Draufsicht auf einen Moldwafer.

In den Figuren bezeichnen gleiche Bezugszeichen gleiche oder funktionsgleiche Bestandteile.

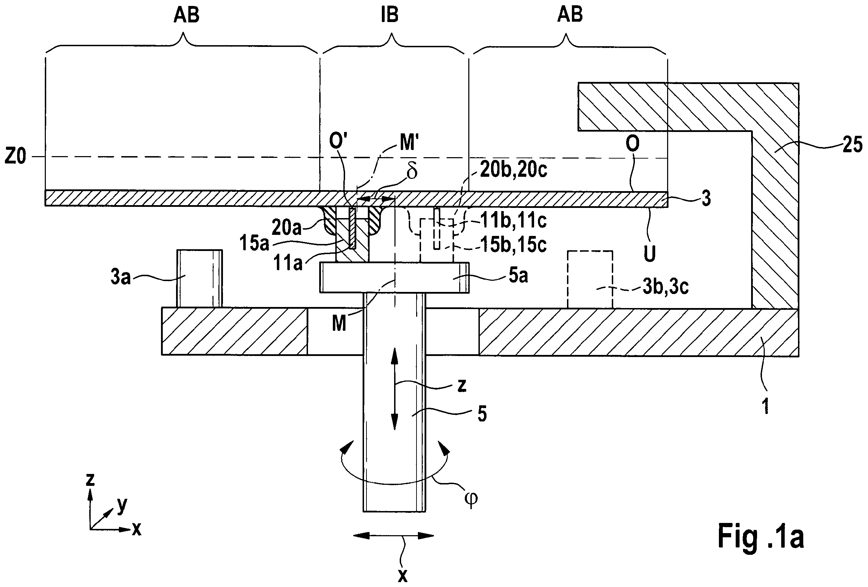

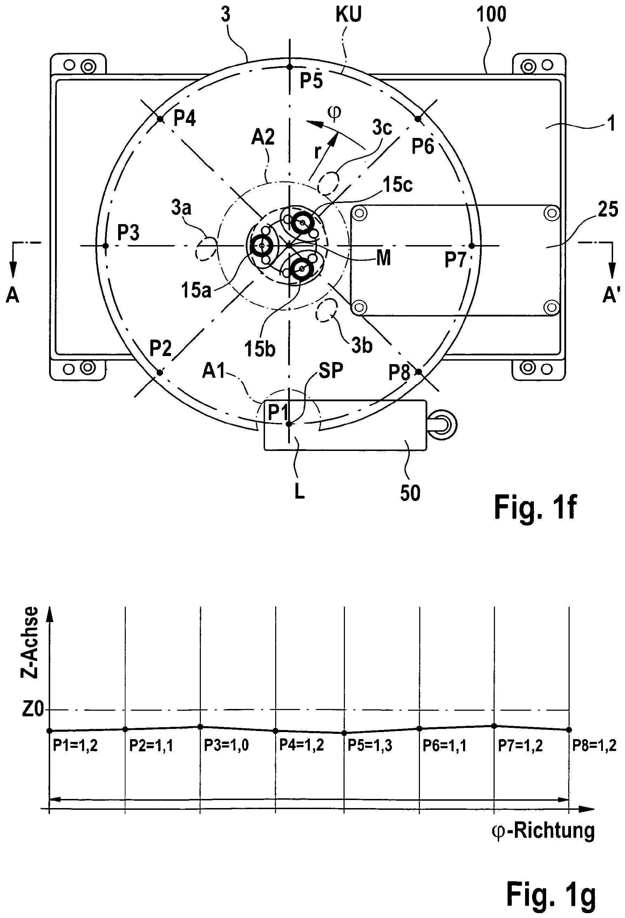

Fig. 1a-c sind schematische Querschnittsdarstellungen einer ersten Ausführungsform der erfindungsgemäßen Vorrichtung zum Ermitteln einer Deformation eines scheibenförmigen Werkstücks, insbesondere eines Moldwafers, entlag der Linie A-A' in Fig. 1f.

In Fig. 1a -1c bezeichnet Bezugszeichen 3 einen Moldwafer aus Kunststoff mit (nicht dargestellten) darin eingebetteten Siliziumchips (vgl. Fig. 4). Der Moldwafer 3 weist einen Innenbereich IB und einen Außenbereich AB in radialer Richtung auf. Der Moldwafer 3 hat eine Oberseite O und eine Unterseite U.

Der Innenbereich IB des Moldwafers 3 ist auf eine Aufspanneinrichtung 5, 5a, 15a-c in einer ersten Aufspannposition aufgespannt, in der die Mittelachse M' des Moldwafers 3 nicht mit der Mittelachse M der achsenzentrierten Aufspanneinrichtung 5, 5a, 15a-c übereinstimmt, sondern um eine Exzentrizität δ davon versetzt ist.

Die Aufspanneinrichtung 5, 5a, 15a-c weist einen Ständerbereich 5 auf, welcher um die Achse M in beliebige Drehwinkel ϕ drehbar ist und welcher zudem in z-Richtung höhenverstellbar ist Weiterhin ist der Ständerbereich 5 seitlich in x-Richtung verstellbar bzw. optional auch in y-Richtung verstellbar. Auf dem Ständerbereich 5 angebracht ist eine rotationssymetrische Trägerplatte 5a, deren Achse mit der Mittelachse M der Aufspanneinrichtung 5, 5a, 15a-c zusammenfällt.

Auf der Oberseite der Trägerplatte 5a befinden sich drei dreiecksförmig äquidistant von der Mittelachse M angeordnete Kontaktelemente 15a, 15b, 15c, welche ein Auflegen und Ansaugen des Moldwafers 3 in dessen Innenbereich IB ermöglichen. Der Innenbereich hat einen Durchmesser von ca. 10 - 30 % des gesamten Moldwafers 3. Im beispielhaften Fall, in dem der Moldwafer 3 einen Durchmesser von 200 mm hat, liegt der Durchmesser des Innenbereichs IB zwischen 20 und 60 mm.

Die Kontaktelemente 15a, 15b, 15c weisen jeweils einen zentralen Auflagestift 11a, 11b, 11c auf, welcher auf eine feste z-Position der Aufspanneinrichtung 5, 5a, 15a-c eingestellt ist, nachdem eine vorgegebene Kalibrierung durchgeführt worden ist, welche später näher erläutert wird. Bei einer (nicht dargestellten) weiteren Ausführungsform sind die Auflagestifte 11a, 11b, 11c automatisch verstellbar, beispielsweise durch eine piezoelektrische Aktoreinrichtung.

Allseitig umgeben sind die Auflagestifte 11a, 11b, 11c von jeweils einem zugehörigen Vakuum-Ansaugelement 20a, 20b, 20c. Die Vakuum-Ansaugelemente 20a, 20b, 20c umfassen eine jeweilige Dichtlippe, welche im nicht aufgelegten Zustand des Moldwafers 3 leicht oberhalb der Höhe O' der Auflagestifte 11a, 11b, 11c abschließt und welche bei Auflegen des Moldwafers 3 durch dessen Gewicht auf die gleiche Höhe wie diejenige der Auflagestifte 11a, 11b, 11c gedrückt wird. Weiterhin umfassen die Vakuumelemente 20a, 20b, 20c eine (nicht dargestellte) Absaugvorrichtung zum Erzeugen eines Vakuums bzw. eines entsprechenden Unterdrucks, um den Moldwafer 3 fest auf den Auflagestiften 11a, 11b, 11c einzuspannen.

Die Kontaktelemente 15b, 15c sind in Fig. 1a - 1c gestrichelt dargestellt, da sie sich ein anderen Querschnittswinkeln befinden, wie aus Fig. 1f ersichtlich.

Die Vorrichtung gemäß Fig. 1a - 1c umfasst weiterhin eine Trägereinrichtung 1, auf der sich eine Ablageeinrichtung 3a, 3b, 3c befindet, welche in der Peripherie einer Ausnehmung 2 der Trägereinrichtung 1 angeordnet ist, durch die die Aufnahmeeinrichtung 5, 5a, 15a-c geführt ist. Die Ablageeinrichtung 3a, 3b, 3c umfasst drei Tragstützen, welche ebenfalls in Dreiecksymmetrie angeordnet sind, wie aus Fig. 1f ersichtlich. Auf den Tragstützen der Ablageeinrichtung 3a, 3b, 3c lässt sich der Moldwafer 3 ablegen, wenn die Aufspanneinrichtung 5, 5a, 15 a- c auf eine entsprechend niedrige z-Position verfahren ist.

Die Tragstützen 3b, 3c sind ebenfalls gestrichelt dargestellt, da sie sich in anderen Schnittwinkeln der Vorrichtung befinden, wie aus Fig. 1f ersichtlich.

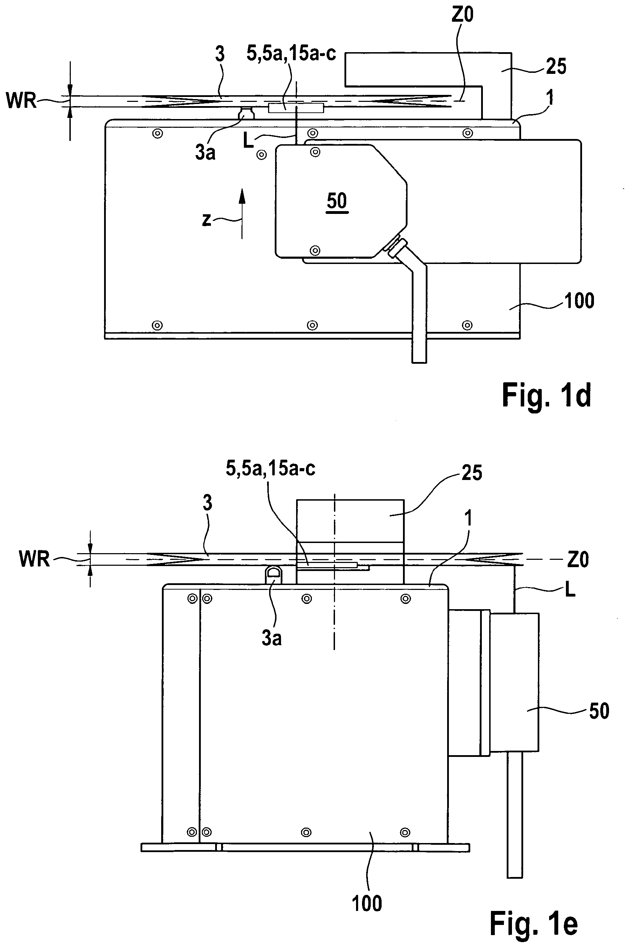

Obwohl in der Fig. 1a - 1c nicht dargestellt, ist die Trägereinrichtung 1 über eine gemeinsame Basis 100 mit der Aufspanneinrichtung 5, 5a, 15a-c verbunden (vgl. Fig. 1d -1f).

Wie bereits oben erwähnt, gibt es eine Exzentrizität δ zwischen der Mittelachse M der Aufspanneinrichtung 5, 5a, 15a-c und der Mittelachse M' des Moldwafers 3 bei der in Fig. 1a gezeigten Aufspannposition.

Zur Ermittlung dieser Exzentrizität δ vorgesehen ist ein sog. Prealigner 25, welcher derart gestaltet ist, dass er bei Drehen der Aufspanneinrichtung 5, 5a, 15a-c um die z-Achse diese Exzentriziät δ optisch nach einem bekannten Verfahren bestimmen kann.

Schließlich bezeichnet Bezugszeichen Z0 in Fig. 1a - 1c eine vorgegebene Höhenposition für die Aufnahmeeinrichtung 5, 5a, 15a-c, welche als Messposition dient, wie später erläutert wird.

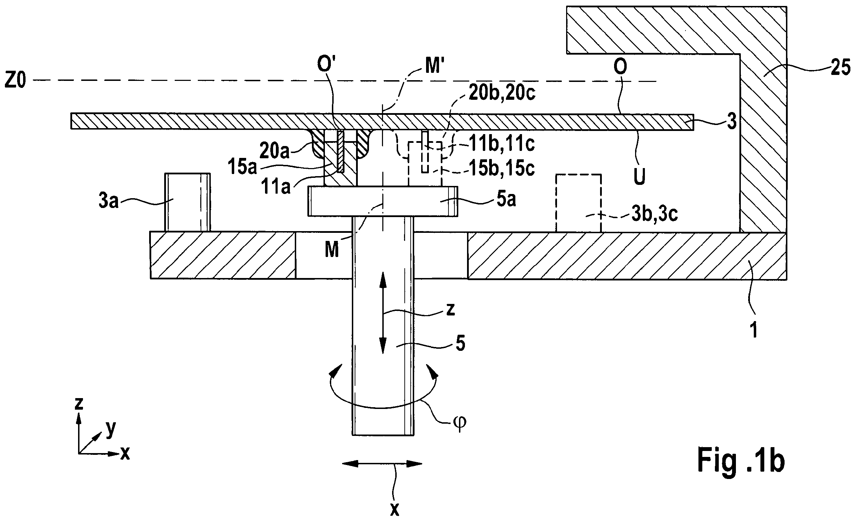

Weiter mit Bezug auf Fig. 1b ist eine zweite Aufspannposition des Moldwafers 3 gezeigt, in der die Mittelachsen M, M' zusammenfallen, also die Exzentrizität δ im Wesentlichen null ist. Diese zweite Aufspannposition wird durch zwischenzeitliches Ablegen des Moldwafers 3 auf den Tragstützen der Ablageeinrichtung 3a, 3b, 3c und ein entsprechendes Umpositionieren der Aufnahmeeinrichtung 5, 5a, 15a-c erreicht, wie später erläutert wird.

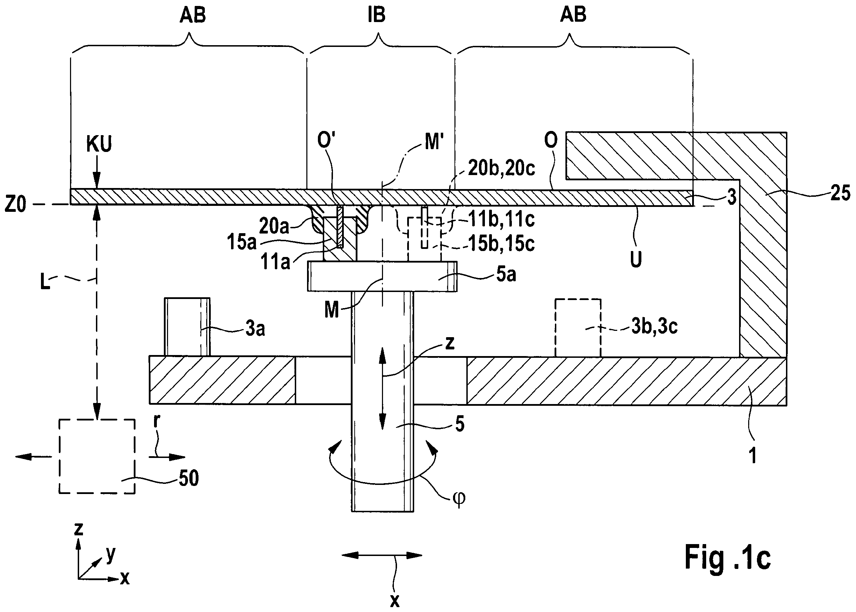

Schließlich mit Bezug auf Fig. 1c ist die Aufspanneinrichtung 5, 5a, 15a-c auch die vorgegebene Höhenposition Z0 gefahren, in der die Messung der Deformation mittels einer höhenfesten Detektoreinrichtung 50 in Form eines Lasermikrometers unter Verwendung eines Laserstrahls L erfolgen kann. Die vorgegebene Höhenposition Z0 ist dann erreicht, wenn sich die Oberseite O' der Auflagestifte 11a, 11b, 11c auf dieser Höhenposition Z0 befindet.

Im in Fig. 1c dargestellten Zustand ist ein idealer Moldwafer 3 dargestellt, welcher keine Deformation bzw. Warpage aufweist. Solch ein idealer Wafer, beispielsweise ein Stahlwafer, lässt sich auch zum Kalibrieren der Vorrichtung in der in Fig. 1c dargestellten Position verwenden.

Fig. 1d,e sind schematische Seitenansichten der ersten Ausführungsform der erfindungsgemäßen Vorrichtung zum Ermitteln einer Deformation eines scheibenförmigen Werkstücks, insbesondere eines Moldwafers.

In Fig. 1d, 1e ist ein Deformationsbereich für Abweichungen WR argestellt, welche ein typischer realer Moldwafer 3 aufweist.

Bei einem Messvorgang an einem derartigen realen Moldwafer 3 wird von der höhenfesten Detektorvorrichtung 50 in Form des Laser-Mikrometers, welche an der Basis 100 befestigt ist, eine jeweilige Abweichung WR von Messpunkten in dem nicht aufgespannten Außenbereich AB des Moldwafers 3 von der vorgegebenen Höhenposition Z0 durch Drehen der Aufspanneinrichtung 5, 5a, 15a-c gemessen. Bei einer nicht dargestellten Ausführungsform könnte auch die Detektoreinrichtung 50 auf ihrer eingestellten Höhe drehbar sein.

Fig. 1f ist eine schematische Draufsicht auf die erste Ausführungsform der erfindungsgemäßen Vorrichtung zum Ermitteln einer Deformation eines scheibenförmigen Werkstücks, insbesondere eines Moldwafers.

Weiter mit Bezug auf Fig. 1f ist der Moldwafer 3 mit zwei virtuellen Ausschnitten A1, A2 dargestellt, durch die die Aufspanneinrichtung 5, 5a, 15a-c und ein Fokuspunkt SP des Laserstrahls L auf der Unterseite U des Moldwafers 3 sichtbar gemacht sind.

Durch Drehen der Aufspanneinrichtung 5, 5a, 15a-c und Durchführung von Messungen an den Messpunkten P1, P2, P3, P4, P5, P6, P7, P8 entlang der Kreisumfangslinie KU mit einem vorgegebenen Radius r lässt sich das in Fig. 1g dargestellte Höhenprofil aufnehmen. Die Punkte P1 - P8 befinden sich dabei an den Messwinkeln ϕ1 - ϕ8.

Fig. 1g ist eine Messdiagramm eines Moldwafers, dessen Defornation mittels der erfindungsgemäßen Vorrichtung zum Ermitteln einer Deformation eines scheibenförmigen Werkstücks gemäß Fig. 1a-f ermittelt worden ist.

Wie auf Fig. 1g ersichtlich, ist der Moldwafer 3 an allen dargestellten Punkten P1 - P8 im Vergleich zur vorgegebenen Höhenposition Z0 nach unten deformiert, hat also eine haubenförmige Gestalt.

Mit Rückbezug auf Fig. 1c ist es ebenfalls möglich, die Detektoreinrichtung 50 in radialer Richtung zum Moldwafer 3 zu verstellen, um ein derartiges Höhenprofil wie in Fig. 1g dargestellt, an verschiedenen Kreisumfängen KU mit verschiedenen Radien r aufzunehmen.

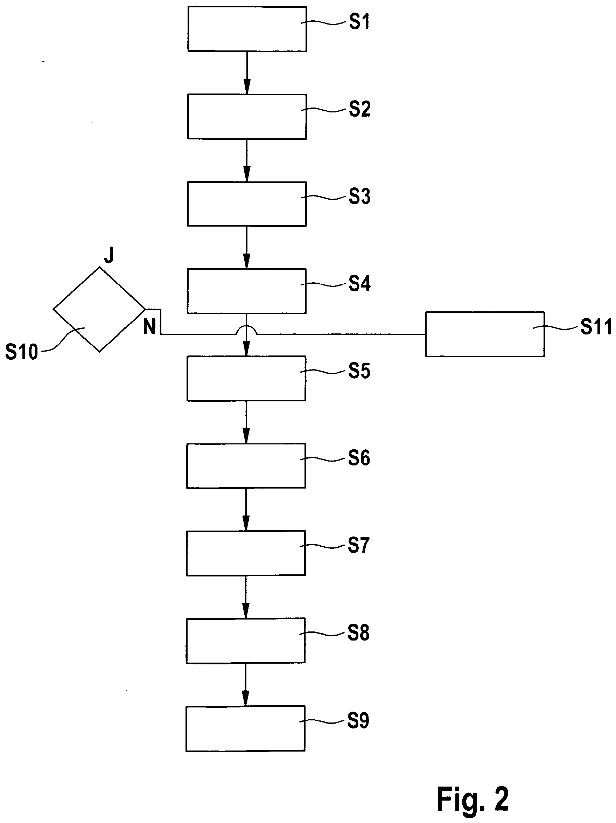

Fig. 2 ist ein Fließdiagramm einer weiteren Ausführungsform des erfindungsgemäßen Verfahrens zum Ermitteln einer Deformation eines scheibenförmigen Werkstücks, insbesondere eines Moldwafers.

In einem nicht dargestellten Verfahrensschritt erfolgt mit einem idealen Wafer 3 wie in Fig. 1c dargestellt eine Kalibrierung der Vorrichtung. Zum Kalibrieren lassen sich insbesondere die Auflagestifte 11a, 11b, 11c verstellen, sodass der ideale Moldwafer mit seiner Unterseite U exakt auf der vorgegebenen Höhenposition Z0 liegt.

Mit Bezug auf Schritt S1 erfolgt dann ein Aufsetzen des Moldwafers 3 auf die Auflagestifte 11a, 11b, 11c der Kontaktelemente 15a, 15b, 15c und ein anschließendes Aufspannen durch Betätigen der Vakuum-Ansaugelemente 20a 20b, 20c, wie in Fig. 1a dargestellt.

Im Anschluss daran erfolgt in Schritt S2 eine Messung der Exzentrizität δ mittels des Prealigners 25 durch eine optische Abtastung während eines Drehens der Aufspanneinrichtung 5, 5a, 15a-c um die z-Achse.

Im Anschluss daran wird die Aufspanneinrichtung 5, 5a, 15a-c in Schritt S3 in eine Winkelposition ϕ gedreht, in der die Exzentrizität δ in x-Richtung auftritt.

Es erfolgt dann in Schritt S4 ein Ablegen des Moldwafers 3 auf den Tragstützen der Ablageeinrichtung 3a, 3b, 3c und ein Lösen und Verfahren der Aufspanneinrichtung 5, 5a, 15a-c in x-Richtung, bis die Exzentrizität δ im Wesentlichen ausgeglichen, also gleich Null, ist. Dies ist der Verfahrenszustand nach Schritt S5.

Im Anschluss daran erfolgt in Schritt S6 ein erneutes Aufspannen des Moldwafers 3 in einer zweiten Aufspannposition und ein Rückfahren in X-Richtung sowie ein anschließendes Anheben auf die vorgegebene Höhenposition Z0, welche gleich der Messposition ist.

In der vorgegebenen Höhenposition Z0 erfolgt dann in Schritt S7, wie bereits in Zusammenhang mit Fig. 1f, 1g beschrieben, ein Messen einer jeweiligen Abweichung MR von den Messpunkten P1 - P8 in dem nicht aufgespannten Außenbereich AB des Moldwafers 3 von der vorgegebenen Höhenposition Z0 mittels der Detektoreinrichtung 50, wobei die Aufspanneinrichtung 5, 5a, 15a-c auf entsprechende Drehwinkel ϕ1 - ϕ8 gedreht wird.

Im Schritt S8 werden die jeweiligen Abweichungen WR von den Messpunkten P1 - P8 zusammen mit den zugehörigen Drehwinkeln ϕ1 - ϕ8 und einer (nicht dargestellten) Werkzeugkennung, wie z. B. einer Wafernummer, in einer Tabelle gespeichert. Zweckmäßig ist es dabei, dass die Drehwinkel ϕ1 - ϕ8 zuvor relativ zu einer Werkzeugmarkierung gewählt worden sind, wie z. B. einer Kerbe, oder einer Abflachung, oder einer optischen Markierung.

In Schritt S9 wird dann die Aufspanneinrichtung 5, 5a, 15a-c gelöst und der Moldwafer 3 entfernt und danach in Schritt S10 geprüft, ob ein weiterer Moldwafer 3 zu vermessen ist. Trifft letzteres zu, so geht das Verfahren zurück zu Schritt Sl, anderenfalls ist das Verfahren in Schritt S11 beendet.

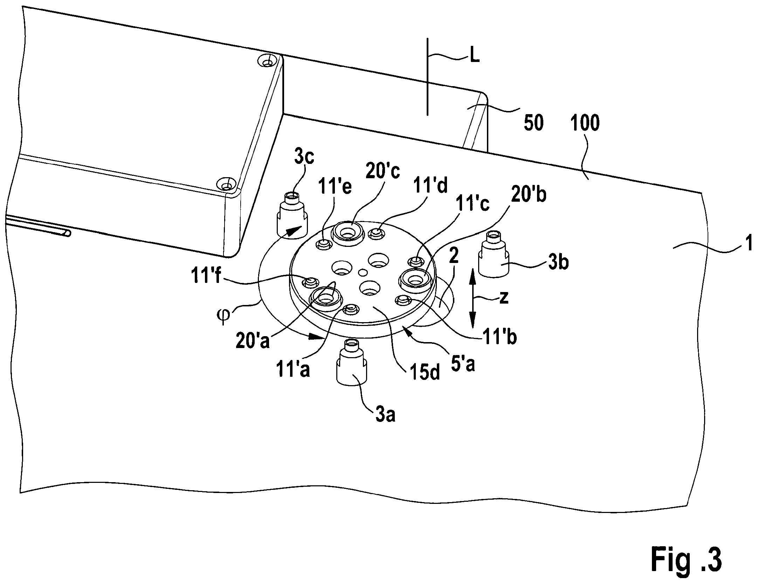

Fig. 3 ist eine schematische perspektivische Ansicht einer zweiten Ausführungsform einer Vorrichtung zum Ermitteln einer Deformation eines scheibenförmigen Werkstücks, insbesondere eines Moldwafers.

Bei der in Fig. 3 gezeigten zweiten Ausführungsform ist anstelle der Kontaktelemente 15a-c der ersten Ausführungsform eine Kontaktelementeinrichtung 15d vorgesehen, welche eine Mehrzahl von Auflagestiften 11'a - 11'f sowie drei Vakuum-Ansaugvorrichtungen 20'a, 20'b und 20'c aufweist. Bei dieser Ausführungsform sind die Auflagestifte 11'a - 11'f nicht durch die Vakuum-Ansaugelemente geführt, sondern separat davon vorgesehen, wobei jeweils zwei Auflagestifte ein Vakuum-Ansaugelement beiderseits flankieren.

Ansonsten ist der Aufbau der zweiten Ausführungsform gleich dem Aufbau der oben beschriebenen ersten Ausführungsform. Insbesondere sei darauf hingewiesen, dass die obigen Ausführungsbeispiele selbstverständlich miteinander kombinierbar sind.

Obwohl die obigen Beispiele die Ermittlung der Deformation von Moldwafern bescheiben, ist die Deformationsermittlung nicht darauf beschränkt, sondern auf beliebige scheibenförmige Werkstücke anwendbar.

Obwohl die obigen Ausführungsformen Aufspanneinrichtungen mit einer Mehrzahl von Auflagepunkten beschreiben, sind diese nicht darauf beschränkt, sondern auch für andere z.B. flächige Aufspannvorrichtungen geeignet, welche die Deformation des Werkstückes nur sehr wenig oder gar nicht beeinflussen. Auch ist auch die Gestalt der Auflagepunktanordnung nur beispielhaft und nicht auf die beschriebene dreieckförmige Anordnung beschränkt.

## Patentansprüche

1. Verfahren zum Ermitteln einer Deformation eines Mouldwafers mit den Schritten:
Aufspannen eines Innenbereichs (IB) des Mouldwafer (3) auf eine Aufspanneinrichtung (5, 5a, 15a-c; 5, 5a, 15d) in einer ersten Aufspannposition;
Ermitteln einer Exzentrizität (δ) einer Mittelachse (M') des Mouldwafers (3) von einer Mittelachse (M) der Aufspanneinrichtung (5, 5a, 15a-c; 5, 5a, 15d) in der ersten Aufspannposition;
Ablegen des Mouldwafers (3) auf eine Ablageeinrichtung (3a, 3b, 3c);
erneutes Aufspannen des Innenbereichs (IB) des Mouldwafers (3) auf die Aufspanneinrichtung (5, 5a, 15a-c; 5, 5a, 15d) in einer zweiten Aufspannposition basierend auf der ermittelten Exzentrizität (δ), wobei die Exzentrizität (δ) in der zweiten Aufspannposition im wesentlichen Null ist;
Verfahren der Aufspanneinrichtung (5, 5a, 15a-c; 5, 5a, 15d) in eine vorgegebene Höhenposition (Z0);
Messen einer jeweiligen Abweichung (WR) von mehreren Messpunkten (P1-P8) in einem nicht aufgespannten Außenbereich (AB) des scheibenförmigen Werkstücks (3) von der vorgegebenen Höhenposition (Z0) entsprechend der Deformation mittels einer höhenfesten Detektoreinrichtung (50) durch Drehen der Aufspanneinrichtung (5, 5a, 15a-c; 5, 5a, 15d) oder der Detektoreinrichtung (50) auf entsprechende Drehwinkel (ϕ1-ϕ8) ;
wobei das Aufspannen des Innenbereichs (IB) des Mouldwafers (3) mit einer Mehrzahl von Auflagestiften (11a, 11b, 11c) und einer Mehrzahl von Vakuum-Ansaugelementen (20a, 20b, 20c) erfolgt;
wobei jeweils ein Auflagestift (11a, 11b, 11c) der Mehrzahl von Auflagestiften (11a, 11b, 11c) von jeweils einem zugehörigen der Mehrzahl von Vakuum-Ansaugelementen (20a, 20b, 20c) umgeben ist;
wobei die Vakuum-Ansaugelemente (20a, 20b, 20c) eine jeweilige Dichtlippe umfassen, welche den jeweiligen zugehörigen Auflagestift (11a, 11b, 11c) umschließt; **dadurch gekennzeichnet, dass** der Mouldwafer (3) im aufgespannten Zustand von den Auflagestiften (11a, 11b, 11c) und den Dichtlippen getragen wird.

2. Verfahren nach Anspruch 1, wobei die mehreren Messpunkten (P1-P8) entlang einer Kreisumfangslinie (KU) angeordnet werden.

3. Verfahren nach Anspruch 1 oder 2, wobei die höhenfeste Detektoreinrichtung (50) ein Lasermikrometer umfasst.

4. Verfahren nach einem der vorhergehenden Ansprüche, wobei die Aufspanneinrichtung (5, 5a, 15a-c; 5, 5a, 15d) in die zweite Aufspannposition durch eine Drehung vor dem Ablegen und eine seitliche Verstellung nach dem Ablegen verfahren wird.

5. Verfahren nach einem der vorhergehenden Ansprüche, wobei der Innenbereich (IB) einen Durchmesser von 10% bis 30% des Mouldwafers (3) aufweist.

6. Verfahren nach einem der vorhergehenden Ansprüche, wobei eine Kalibrierung des Messens mit einem Normwerkzeug ohne Deformation durchgeführt wird.

7. Verfahren nach einem der vorhergehenden Ansprüche, wobei die jeweiligen Abweichungen (WR) von den mehreren Messpunkten (P1-P8) zusammen mit den zugehörigen Drehwinkeln (ϕ1-ϕ8) und einer Werkzeugkennung in einer Tabelle gespeichert werden.

8. Verfahren nach einem der vorhergehenden Ansprüche, wobei die Drehwinkel (ϕ1-ϕ8) relativ zu einer Werkzeugmarkierung gewählt werden.

9. Vorrichtung zum Ermitteln einer Deformation eines Mouldwafers mit:
einer drehbaren, höhen- und seitenverstellbaren Aufspanneinrichtung (5, 5a, 15a-c; 5, 5a, 15d) zum Aufspannen einen Innenbereichs (IB) des Mouldwafers (3);
einer Ermittlungseinrichtung (25) zum Ermitteln einer Exzentrizität (δ) einer Mittelachse (M') des Mouldwafers(3) von einer Mittelachse (M) der Aufspanneinrichtung (5, 5a, 15a-c; 5, 5a, 15d) und zum Erzeugen eines entsprechenden Verstellsignals für die Aufspanneinrichtung (5, 5a, 15a-c; 5, 5a, 15d);
einer Ablageeinrichtung (3a, 3b, 3c) zum Ablegen des scheibenförmigen Werkstücks (3) während eines seitlichen Verstellvorgangs der Aufspanneinrichtung (5, 5a, 15a-c; 5, 5a, 15d); und
einer höhenfesten Detektoreinrichtung (50) zum Messen einer jeweiligen Abweichung (WR) von mehreren Messpunkten (P1-P8) in einem nicht aufgespannten Außenbereich (AB) Mouldwafers (3) von einer vorgegebenen Höhenposition (Z0) entsprechend der Deformation mittels einer Drehung der Aufspanneinrichtung (5, 5a, 15a-c; 5, 5a, 15d) oder der Detektoreinrichtung (50) bei einer vorgegebenen Höhenposition (Z0) der Aufspanneinrichtung (5, 5a, 15a-c; 5, 5a, 15d);
wobei die Aufspanneinrichtung (5, 5a, 15a-c; 5, 5a, 15d) eine Mehrzahl von Auflagestiften (11a, 11b, 11c) und eine Mehrzahl von Vakuum-Ansaugelementen (20a, 20b, 20c) aufweist;
wobei jeweils ein Auflagestift (11a, 11b, 11c) der Mehrzahl von Auflagestiften (11a, 11b, 11c) von jeweils einem zugehörigen der Mehrzahl von Vakuum-Ansaugelementen (20a, 20b, 20c) umgeben ist;
wobei die Vakuum-Ansaugelemente (20a, 20b, 20c)eine jeweilige Dichtlippe umfassen, welche den jeweiligen zugehörigen Auflagestift (11a, 11b, 11c) umschließt; **dadurch gekennzeichnet, dass** der Mouldwafer (3) im aufgespannten Zustand von den Auflagestiften (11a, 11b, 11c) und den Dichtlippen tragbar ist.

10. Vorrichtung nach Anspruch 9, wobei die Auflagestifte (11a, 11b, 11c) höhenverstellbar sind.

11. Vorrichtung nach einem der Ansprüche 9 oder 10, wobei die Aufspanneinrichtung (5, 5a, 15a-c; 5, 5a, 15d) durch eine Ausnehmung (2) einer Trägereinrichtung (1) geführt ist und die Ablageeinrichtung (3a, 3b, 3c) in der Peripherie der Ausnehmung (2) vorgesehen ist.

12. Vorrichtung nach Anspruch 11, wobei die Ablageeinrichtung (3a, 3b, 3c) eine Mehrzahl von Tragstützen umfasst.

13. Vorrichtung nach einem der Ansprüche 11 oder 12, wobei die höhenfeste Detektoreinrichtung (50) an der Trägereinrichtung (1) angebracht ist.

14. Vorrichtung nach einem der Ansprüche 9 bis 13, wobei die höhenfeste Detektoreinrichtung (50) ein Lasermikrometer umfasst.

15. Vorrichtung nach einem der Ansprüche 9 bis 14, wobei die Ermittlungseinrichtung (25) an der Trägereinrichtung (1) angebracht ist.

16. Vorrichtung nach einem der Ansprüche 9 bis 15, wobei die Ermittlungseinrichtung (25) einen Prealigner umfasst.

17. Vorrichtung nach einem der Ansprüche 9 bis 16, wobei die Detektoreinrichtung (50) radial bezüglich des Werkstücks (3) verstellbar ist.

## Claims

1. Method for determining a deformation of a mould wafer, having the steps of:
clamping an inner region (IB) of the mould wafer (3) on a clamping device (5, 5a, 15a-c; 5, 5a, 15d) in a first clamping position;
determining an eccentricity (δ) of a central axis (M') of the mould wafer (3) from a central axis (M) of the clamping device (5, 5a, 15a-c; 5, 5a, 15d) in the first clamping position;
depositing the mould wafer (3) on a supporting device (3a, 3b, 3c);
re-clamping the inner region (IB) of the mould wafer (3) on the clamping device (5, 5a, 15a-c; 5, 5a, 15d) in a second clamping position on the basis of the determined eccentricity (δ), wherein the eccentricity (δ) in the second clamping position is substantially zero;
moving the clamping device (5, 5a, 15a-c; 5, 5a, 15d) into a predetermined height position (Z0);
measuring a respective deviation (WR) of a plurality of measuring points (P1-P8) in a non-clamped outer region (AB) of the disk-shaped workpiece (3) from the predetermined height position (Z0) as per the deformation by means of a fixed-height detector device (50) by rotating the clamping device (5, 5a, 15a-c; 5, 5a, 15d) or the detector device (50) to corresponding angles of rotation (ϕ1-ϕ8);
wherein the clamping of the inner region (IB) of the mould wafer (3) takes place using a plurality of bearing pins (11a, 11b, 11c) and a plurality of vacuum suction elements (20a, 20b, 20c);
wherein in each case one bearing pin (11a, 11b, 11c) of the plurality of bearing pins (11a, 11b, 11c) is surrounded by in each case one associated one of the plurality of vacuum suction elements (20a, 20b, 20c);
wherein the vacuum suction elements (20a, 20b, 20c) comprise a respective sealing lip that encloses the respective associated bearing pin (11a, 11b, 11c);
**characterized in that** the mould wafer (3) in the clamped state is carried by the bearing pins (11a, 11b, 11c) and the sealing lips.

2. Method according to Claim 1, wherein the plurality of measuring points (P1-P8) are arranged along a circumferential line (KU).

3. Method according to Claim 1 or 2, wherein the fixed-height detector device (50) comprises a laser micrometer.

4. Method according to one of the preceding claims, wherein the clamping device (5, 5a, 15a-c; 5, 5a, 15d) is moved into the second clamping position by rotation prior to the deposition and a lateral adjustment after the deposition.

5. Method according to one of the preceding claims, wherein the inner region (IB) has a diameter of 10% to 30% of the mould wafer (3).

6. Method according to one of the preceding claims, wherein a calibration of the measuring is carried out with a standard tool without deformation.

7. Method according to one of the preceding claims, wherein the respective deviations (WR) of the plurality of measuring points (P1-P8) are saved together with the associated angles of rotation (ϕ1-ϕ8) and a tool identifier in a table.

8. Method according to one of the preceding claims, wherein the angles of rotation (ϕ1-ϕ8) are selected relative to a tool marking.

9. Apparatus for determining a deformation of a mould wafer, having:
a rotatable, vertically and laterally adjustable clamping device (5, 5a, 15a-c; 5, 5a, 15d) for clamping an inner region (IB) of the mould wafer (3);
a determining device (25) for determining an eccentricity (δ) of a central axis (M') of the mould wafer (3) from a central axis (M) of the clamping device (5, 5a, 15a-c; 5, 5a, 15d) and for generating a corresponding adjustment signal for the clamping device(5, 5a, 15a-c; 5, 5a, 15d);
a supporting device (3a, 3b, 3c) for depositing the disk-shaped workpiece (3) during a lateral adjustment operation of the clamping device (5, 5a, 15a-c; 5, 5a, 15d); and
a fixed-height detector device (50) for measuring a respective deviation (WR) of a plurality of measuring points (P1-P8) in a non-clamped outer region (AB) of the mould wafer (3) from a predetermined height position (Z0) as per the deformation by means of a rotation of the clamping device (5, 5a, 15a-c; 5, 5a, 15d) or of the detector device (50) at a predetermined height position (Z0) of the clamping device (5, 5a, 15a-c; 5, 5a, 15d);
wherein the clamping device (5, 5a, 15a-c; 5, 5a, 15d) has a plurality of bearing pins (11a, 11b, 11c) and a plurality of vacuum suction elements (20a, 20b, 20c);
wherein in each case one bearing pin (11a, 11b, 11c) of the plurality of bearing pins (11a, 11b, 11c) is surrounded by in each case one associated one of the plurality of vacuum suction elements (20a, 20b, 20c);
wherein the vacuum suction elements (20a, 20b, 20c) comprise a respective sealing lip that encloses the respective associated bearing pin (11a, 11b, 11c);
**characterized in that** the mould wafer (3) in the clamped state is able to be carried by the bearing pins (11a, 11b, 11c) and the sealing lips.

10. Apparatus according to Claim 9, wherein the bearing pins (11a, 11b, 11c) are vertically adjustable.

11. Apparatus according to either of Claims 9 and 10, wherein the clamping device (5, 5a, 15a-c; 5, 5a, 15d) is guided by a cutout (2) in a carrier device (1) and the supporting device (3a, 3b, 3c) is provided in the periphery of the cutout (2).

12. Apparatus according to Claim 11, wherein the supporting device (3a, 3b, 3c) comprises a plurality of supports.

13. Apparatus according to either of Claims 11 and 12, wherein the fixed-height detector device (50) is attached to the carrier device (1).

14. Apparatus according to one of Claims 9 to 13, wherein the fixed-height detector device (50) comprises a laser micrometer.

15. Apparatus according to one of Claims 9 to 14, wherein the determining device (25) is attached to the carrier device (1).

16. Apparatus according to one of Claims 9 to 15, wherein the determining device (25) comprises a prealigner.

17. Apparatus according to one of Claims 9 to 16, wherein the detector device (50) is adjustable radially with respect to the workpiece (3).

## Revendications

1. Procédé de détermination d'une déformation d'une plaquette moulée, comprenant les étapes suivantes :
serrage d'une région intérieure (IB) de la plaquette moulée (3) sur un dispositif de serrage (5, 5a, 15a à 15c ; 5, 5a, 15d), dans une première position de serrage ;
détermination d'une excentricité (δ) d'un axe central (M') de la plaquette moulée (3) par rapport à un axe central (M) du dispositif de serrage (5, 5a, 15a à 15c ; 5, 5a, 15d), dans la première position de serrage ;
dépôt de la plaquette moulée (3) sur un dispositif de réception (3a, 3b, 3c) ;
nouveau serrage de la région intérieure (IB) de la plaquette moulée (3) sur le dispositif de serrage (5, 5a, 15a à 15c ; 5, 5a, 15d), dans une deuxième position de serrage en fonction de l'excentricité (δ) déterminée, l'excentricité (δ) étant essentiellement nulle dans ladite deuxième position de serrage ;
amenée du dispositif de serrage (5, 5a, 15a à 15c ; 5, 5a, 15d) dans une position en hauteur (Z0) prédéterminée ; mesurage d'un écart (WR), par rapport à ladite position en hauteur prédéterminée (Z0) correspondant à la déformation, de plusieurs points de mesure (P1 à P8) situés dans une région extérieure (AB) non serrée de la pièce en forme de disque (3), au moyen d'un dispositif de détection (50) fixe en hauteur par rotation du dispositif de serrage (5, 5a, 15a à 15c ; 5, 5a, 15d) ou du dispositif de détection (50) selon un angle de rotation correspondant (ϕ1 à ϕ8) ;
ladite région intérieure (IB) de la plaquette moulée (3) étant serrée par plusieurs goupilles d'appui (11a, 11b, 11c) et par plusieurs éléments d'aspiration par le vide (20a, 20b, 20c) ;
à chaque fois une goupille d'appui (11a, 11b, 11c) de la pluralité desdites goupilles d'appui (11a, 11b, 11c) étant entourée par un parmi la pluralité des éléments d'aspiration par le vide (20a, 20b, 20c) lui correspondant ;
chaque élément d'aspiration par le vide (20a, 20b, 20c) comprenant une lèvre d'étanchéité entourant la goupille d'appui (11a, 11b, 11c) respective lui correspondant, ledit procédé **caractérisé en ce que** la plaquette moulée (3), dans l'état serré, est supportée par les goupilles d'appui (11a, 11b, 11c) et par lesdites lèvres d'étanchéité.

2. Procédé selon la revendication 1, dans lequel les points de mesure (P1 à P8) sont disposés le long d'une ligne périphérique circulaire (KU).

3. Procédé selon l'une quelconque des revendications 1 ou 2, dans lequel le dispositif de détection (50) fixe en hauteur comprend un micromètre à laser.

4. Procédé selon l'une quelconque des revendications précédentes, dans lequel le dispositif de serrage (5, 5a, 15a à 15c ; 5, 5a, 15d) est amené dans la deuxième position de serrage par une rotation intervenant avant l'étape de dépôt et un déplacement latéral intervenant après l'étape de dépôt.

5. Procédé selon l'une quelconque des revendications précédentes, dans lequel la région intérieure (IB) présente un diamètre de 10 % à 30 % de celui de la plaquette moulée (3).

6. Procédé selon l'une quelconque des revendications précédentes, dans lequel le mesurage est étalonné en l'absence de déformation à l'aide d'un outil normalisé.

7. Procédé selon l'une quelconque des revendications précédentes, dans lequel les écarts (WR) de la pluralité de points de mesure (P1 à P8) sont enregistrés dans un tableau avec les angles de rotation (ϕ1 à ϕ8) correspondants et une désignation d'outil.

8. Procédé selon l'une quelconque des revendications précédentes, dans lequel les angles de rotation (ϕ1 à ϕ8) sont choisis par rapport à un marquage d'outil.

9. Dispositif de détermination d'une déformation d'une plaquette moulée comprenant :
un dispositif de serrage (5, 5a, 15a à 15c ; 5, 5a, 15d) mobile en rotation, en hauteur et latéralement, destiné à serrer une région intérieure (IB) de la plaquette moulée (3) ;
un dispositif de détermination (25) destiné à déterminer une excentricité (ϕ) d'un axe central (M') de la plaquette moulée (3) par rapport à un axe central (M) du dispositif de serrage (5, 5a, 15a à 15c ; 5, 5a, 15d) et à produire un signal de déplacement correspondant pour ledit dispositif de serrage (5, 5a, 15a à 15c ; 5, 5a, 15d) ;
un dispositif de réception (3a, 3b, 3c) destiné à déposer la pièce en forme de disque (3) pendant un déplacement latéral du dispositif de serrage (5, 5a, 15a à 15c ; 5, 5a, 15d) ;
un dispositif de détection (50) fixe en hauteur, destiné à mesurer un écart (WR), par rapport à une position en hauteur prédéterminée (Z0) correspondant à la déformation, de plusieurs points de mesure (P1 à P8) situés dans une région extérieure (AB) non serrée de la plaquette moulée (3), au moyen d'une rotation du dispositif de serrage (5, 5a, 15a à 15c ; 5, 5a, 15d) ou du dispositif de détection (50) pour une position en hauteur (Z0) donnée dudit dispositif de serrage (5, 5a, 15a à 15c ; 5, 5a, 15d) ;
ledit dispositif de serrage (5, 5a, 15a à 15c ; 5, 5a, 15d) comportant plusieurs goupilles d'appui (11a, 11b, 11c) et plusieurs éléments d'aspiration par le vide (20a, 20b, 20c) ;
à chaque fois une goupille d'appui (11a, 11b, 11c) de la pluralité desdites goupilles d'appui (11a, 11b, 11c) étant entourée par un parmi la pluralité des éléments d'aspiration par le vide (20a, 20b, 20c) lui correspondant ;
chaque élément d'aspiration par le vide (20a, 20b, 20c) comprenant une lèvre d'étanchéité entourant la goupille d'appui (11a, 11b, 11c) lui correspondant, **caractérisé en ce que** la plaquette moulée (3), dans l'état serré, peut être supportée par les goupilles d'appui (11a, 11b, 11c) et par lesdites lèvres d'étanchéité.

10. Dispositif selon la revendication 9, dans lequel les goupilles d'appui (11a, 11b, 11c) sont réglables en hauteur.

11. Dispositif selon l'une quelconque des revendications 9 ou 10, dans lequel le dispositif de serrage (5, 5a, 15a à 15c ; 5, 5a, 15d) est guidé par un évidement (2) pratiqué dans un dispositif de support (1) et le dispositif de réception (3a, 3b, 3c) est prévu à la périphérie dudit évidement (2).

12. Dispositif selon la revendication 11, dans lequel le dispositif de réception (3a, 3b, 3c) comprend plusieurs colonnes de support.

13. Dispositif selon l'une quelconque des revendications 11 ou 12, dans lequel le dispositif de détection (50) fixe en hauteur est monté sur le dispositif de support (1).

14. Dispositif selon une quelconque des revendications 9 à 13, dans lequel le dispositif de détection (50) fixe en hauteur comprend un micromètre à laser.

15. Dispositif selon l'une quelconque des revendications 9 à 14, dans lequel le dispositif de détermination (25) est monté sur le dispositif de support (1).

16. Dispositif selon l'une quelconque des revendications 9 à 15, dans lequel le dispositif de détermination (25) comprend un préaligneur.

17. Dispositif selon l'une quelconque des revendications 9 à 16, dans lequel le dispositif de détection (50) est réglable radialement par rapport à la pièce (3).
